# EUROPÄISCHE PATENTSCHRIFT

(11) **EP 3 089 843 B1**
(45) Veröffentlichungstag und Bekanntmachung des Hinweises auf die Patenterteilung: **15.06.2022**
(21) Anmeldenummer: 15793691.5
(22) Anmeldetag: 29.10.2015
(51) Int. Cl.: B23K 20/00, B60Q 1/00, H05K 3/32, H01L 23/00, H05K 3/36, B23K 101/32, B23K 101/38

(54) **VERFAHREN UND VORRICHTUNG ZUM VERBINDEN EINES DRAHTES**
METHOD AND DEVICE FOR CONNECTING A WIRE
PROCÉDÉ ET DISPOSITIF POUR CONNECTER UN FIL

(30) Priorität: 05.11.2014 AT 508112014
(43) Veröffentlichungstag der Anmeldung: 09.11.2016
(73) Patentinhaber: ZKW Group GmbH, 3250 Wieselburg (AT)
(72) Erfinder: BISSINGER, Stephan, A-2700 Wr. Neustadt (AT); HAJEK, Liron, A-2823 Pitten (AT); HIEGER, Christof, A-3142 Perschling (AT)
(74) Vertreter: Patentanwaltskanzlei Matschnig & Forsthuber OG
(86) Internationale Anmeldenummer: PCT/AT2015/050274
(87) Internationale Veröffentlichungsnummer: WO 2016/070211

(56) Entgegenhaltungen:
- JP-A- S6 344 733
- JP-A- H01 128 441
- JP-A- S59 123 249
- JP-A- 2006 275 594
- JP-A- 2014 049 522
- US-A1- 2008 124 547

## Beschreibung

Die Erfindung betrifft ein Drahtbondingverfahren zum Herstellen einer elektrischen Verbindung zwischen einem ersten Bondkörper mit einer ersten zu kontaktierenden Bondfläche und einem zweiten Bondkörper mit einer zweiten zu kontaktierenden Bondfläche, wobei die ersten und zweiten Bondflächen unterschiedliche Neigungen aufweisen.

Die Erfindung betrifft ferner einen Drahtbondingkopf zum Durchführen des erfindungsgemäßen Verfahrens.

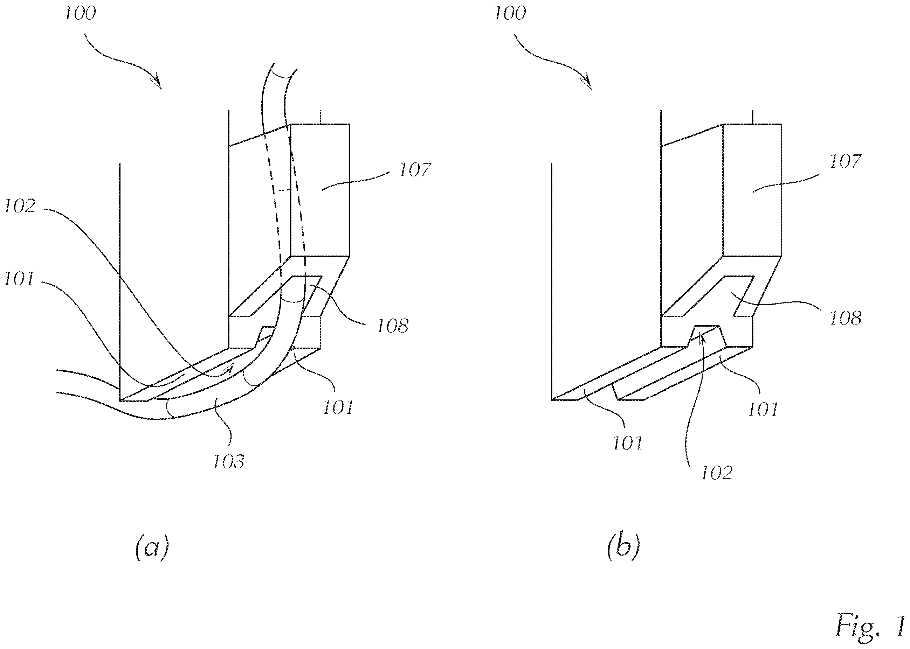

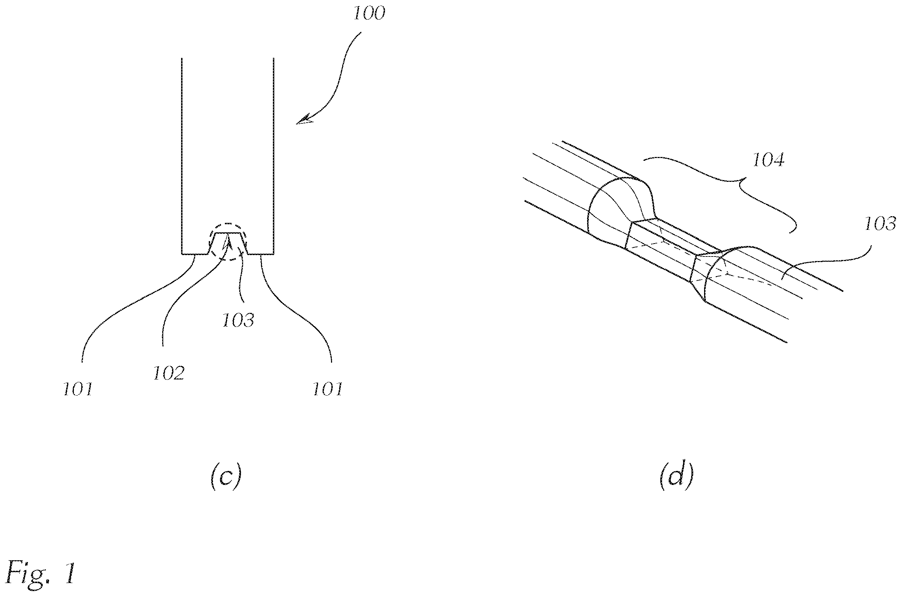

Beim Drahtbonding (auch als Wedgebonding bezeichnet) handelt es sich um ein bekanntes und häufig eingesetztes sono-elektrisches Verfahren, mit welchem mittels Ultraschall ein Verbindungsdraht auf einer Kontaktfläche einer Leiterplatte angebracht wird. Der Verbindungsdraht (Bonddraht), der üblicherweise aus Aluminium, Kupfer, Silber oder Gold besteht, wird mit Hilfe eines Drahtbondingkopfs (auch als Bondingwerkzeug oder Wedge Tool bezeichnet) auf der Kontaktfläche angepresst. Gängige Drahtbondingköpfe weisen eine im Wesentlichen keilförmige Spitze mit einer Anpressfläche sowie eine Zuführung für den Bonddraht auf. Zum Herstellen der Bondverbindung wird der über die Anpressfläche geführte Bonddraht gegen die Kontaktfläche der Leiterplatte gepresst und gleichzeitig werden im Bondingkopf Ultraschallschwingungen erzeugt, wodurch der Draht mit der Kontaktfläche auf atomarer Ebene verbunden wird. Fig. 1a-c zeigen einen in herkömmlichen Drahtbondingverfahren eingesetzten Drahtbondingkopf 100 gemäß dem Stand der Technik. Der Drahtbondingkopf 100 besitzt eine Anpressfläche 101 mit einer Führung 102 für einen Bonddraht 103. Der Bondingkopf 100 verfügt außerdem über eine Zuführung 107 für den Bonddraht 103, die nach an sich bekannter Art aufgebaut ist und eine Öffnung 108 aufweist, durch die der Bonddraht 103 zugeführt bzw. geführt wird. Wie in Fig. 1c gezeigt, hat die Führung 102 einen kleineren Querschnitt als der Bonddraht 103, weshalb der Bonddraht 103 unter Ultraschalleinwirkung und durch Pressen der Anpressfläche 101 des Bondingkopfs 100 gegen eine (nicht dargestellte) Kontaktfläche einer Leiterplatte mit der Kontaktfläche verbunden wird. Nach dem Herstellen der ersten Bondverbindung wird der Bondingkopf 100 z.B. mittels Schrittmotoren zur Kontaktfläche einer weiteren Leiterpleite weiterbewegt, um eine zweite Bondverbindung und somit eine elektrische Verbindung zwischen den beiden Leiterplatten herzustellen. Die zum Bonding verwendeten Drähte sind sehr fein; z.B. kann der Bonddraht 103 einen Querschnitt von ca. 500 µm aufweisen. Golddrähte haben eine Dicke bis zu 25 µm. Der Bondingkopf 100 ist in Richtung des Drahtes etwa 1,5 mm lang. Fig. 1d zeigt die Verjüngung 104 des Drahtquerschnitts, wenn man den Bonddraht 103 auf eine Kontaktfläche bondet, die im Wesentlichen parallel zur Anpressfläche des Bondingkopfs ist.

In Kraftfahrzeugscheinwerferanwendungen ist es notwendig, getrennt montierte Leiterplatten (hierin auch als Platinen oder Boards bezeichnet) elektrisch zu verbinden. Hierfür ist eine entsprechende Neigung der einzelnen Leiterplatten erforderlich, so dass Lichtquellen auf den Leiterplatten zu optischen Achsen von Linsen oder Reflektoren ausgerichtet werden können. Beispielsweise können die Leiterplatten in Scheinwerferanwendungen einen Kippwinkel von ca. 10 Grad aufweisen. Darüber hinaus liegen die einzelnen Leiterplatten zumeist auf unterschiedlichen Höhenstufen. Zusätzlich unterliegen die Leiterplatten häufig einer prozessbedingten Schwankung von +/-1° in der x- und y-Achse.

Nach dem derzeitigem Stand der Technik werden getrennt montierte Leiterplatten mit unterschiedlichen Bezugseben, z.B. Leiterplatten für Scheinwerferanwendungen, mit Hilfe von flexiblen Prints verbunden, die auf Pads von Leiterbahnen gelötet werden und vorgeformt sind. Dieses Verfahren ist jedoch kostenintensiv und aufwändig.

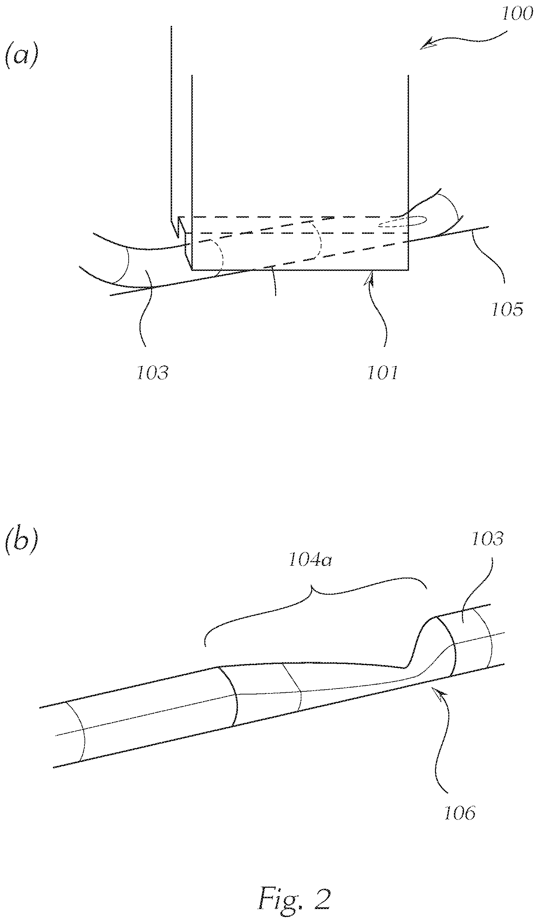

Das oben beschriebene Drahtbondingverfahren mittels eines Drahtbondingkopfs 100 gemäß Fig. 1a-c ist für das elektrische Verbinden von Leiterplatten mit unterschiedlichen Bezugsebenen, z.b. bei Scheinwerferanwendungen, nicht in zufrieden stellender Weise geeignet. Der Begriff "unterschiedliche Bezugsebene" bedeutet, dass die Kontaktflächen der Leiterplatten unterschiedliche Neigungen aufweisen. Darüber hinaus können sich die Leiterplatten auch noch auf unterschiedlichen Höhenstufen befinden. Die Problematik eines in herkömmlicher Weise durchgeführten Drahtbondingverfahrens zum Herstellen einer elektrischen Verbindung zwischen zueinander geneigten Substratflächen ist in den Fig. 2a-b veranschaulicht. Wie darin erkennbar ist, ist die beim Drahtbonding entstehende Verjüngung 104a des Querschnitts des Bonddrahtes 103 aufgrund der unterschiedlichen Neigungen der Anpressfläche 101 des Drahtbondingkopfs 100 und der Substratfläche 105 nicht gleichmäßig, so dass der gebondete Draht 103 an der Stelle, wo die Deformation am größten ist (mit dem Bezugszeichen 106 gekennzeichnet), weniger Haftung hat und leichter reißt. Aus Gründen der besseren Darstellbarkeit ist die Zuführung 107 in Fig. 2a nicht gezeigt, auch wenn der Bondingkopf 100 eine solche aufweist (siehe Fig. 1a-c).

Die US 3,934,783 offenbart eine Drahtbondingvorrichtung mit einem Drahtbondingkopf, der unterschiedlich geneigte Anpressflächen und eine Zuführung für einen Bonddraht aufweist. Die in Bezug auf eine horizontale Substratoberfläche unterschiedlich geneigten Anpressflächen haben den Zweck, den Bonddraht an der ersten und zweiten Bondverbindung auf einer planen, horizontalen Substratoberfläche mit einer unterschiedlichen Verjüngung des Drahtquerschnitts anzupressen. Dadurch wird ein leichterer Abriss des Drahts ermöglicht, wenn der Draht auf horizontalen Flächen aufgepresst wird. Die geneigten Anpressflächen des Bondingkopfs sind am Bondingkopf senkrecht zur Laufrichtung des Bonddrahts angeordnet, so dass sich der Bonddraht durch seitliches Verschieben über jede der beiden Anpressflächen führen lässt.

Beispielsweise offenbart die JP 2006 275594 A, die US 2008/124547, die JP H01 128441 A und die JP S59 123249 A ein Drahtbondingverfahren aus dem Stand der Technik. Die JP 2014 049522 A offenbart beispielsweise einen Drahtbondingkopf aus dem Stand der Technik. Die unabhängigen Ansprüche sind gegen die JP 2006 275594 A abgegrenzt.

Es ist daher eine Aufgabe der Erfindung, das Verlöten von flexiblen Prints als derzeit standardmäßiges Verfahren auf vorteilhafte Weise abzulösen und ein Verfahren bereitzustellen, mit dem eine kostengünstige und einfach zu realisierende elektrische Verbindung zwischen geometrisch aufwendigen Topologien wie zwischen unterschiedlich geneigten Leiterplatten herstellbar ist.

Der Erfindung liegt ferner die Aufgabe zugrunde, einen Drahtbondingkopf bereitzustellen, der bei der Durchführung des erfindungsgemäßen Verfahrens in vorteilhafter Weise eingesetzt werden kann.

Diese Aufgabe wird dadurch gelöst, dass zum Herstellen einer elektrischen Verbindung zwischen einem ersten Bondkörper mit einer ersten zu kontaktierenden Bondfläche und einem zweiten Bondkörper mit einer zweiten zu kontaktierenden Bondfläche, wobei die ersten und zweiten Bondflächen unterschiedliche Neigungen aufweisen, anstelle des Verlötens von flexiblen Prints ein Drahtbondingverfahren bereitgestellt wird, welches die folgenden Verfahrensschritte aufweist:
a) Bereitstellen eines Drahtbondingkopfs mit zwei unterschiedlich geneigten Anpressflächen und einer Zuführung für einen Bonddraht, wobei die Neigung der ersten Anpressfläche im Wesentlichen der Neigung der ersten Bondfläche entspricht und wobei die Neigung der zweiten Anpressfläche im Wesentlichen der Neigung der zweiten Bondfläche entspricht,
b) Herstellen einer ersten Bondverbindung zwischen dem Bonddraht und dem ersten Bondkörper, wobei der Draht mittels der ersten Anpressfläche des Drahtbondingkopfs durch Ultraschallbonding mit der ersten Bondfläche verbunden wird, und
c) Herstellen einer zweiten Bondverbindung zwischen dem Draht und dem zweiten Bondkörper, wobei der Draht mittels der zweiten Anpressfläche des Drahtbondingkopfs durch Ultraschallbonding mit der zweiten Bondfläche verbunden wird.

Diese Aufgabe wird ferner durch einen Drahtbondingkopf gelöst, der wie eingangs genannt zwei unterschiedlich geneigte Anpressflächen und eine Zuführung für einen Bonddraht aufweist, wobei der Drahtbondingkopf erfindungsgemäß dadurch gekennzeichnet ist, dass er zum Herstellen einer elektrischen Verbindung zwischen einem ersten Bondkörper mit einer ersten zu kontaktierenden Bondfläche und einem zweiten Bondkörper mit einer zweiten zu kontaktierenden Bondfläche eingerichtet ist, wobei die ersten und zweiten Bondflächen unterschiedliche Neigungen aufweisen, wobei die Neigung der ersten Anpressfläche im Wesentlichen der Neigung der ersten Bondfläche entspricht und wobei die Neigung der zweiten Anpressfläche im Wesentlichen der Neigung der zweiten Bondfläche entspricht, und wobei die Anpressflächen am Bondingskopfs hintereinander in Laufrichtung des Bonddrahtes positioniert sind.

Dank der Erfindung ist es möglich, auf kostengünstige Weise eine sichere elektrische Verbindung zwischen zwei Bondkörpern, z.B. zwei Leiterplatten, mit unterschiedlichen Bezugsebenen herzustellen. Wie oben erwähnt bezieht sich der Begriff "unterschiedliche Bezugsebene" darauf, dass die Kontaktflächen der Leiterplatten unterschiedliche Neigungen aufweisen. Darüber hinaus können sich die Leiterplatten auch auf unterschiedlichen Höhenstufen befinden. Die Erfindung ermöglicht eine verbesserte Flexibilität in der Geometrie der elektrischen Verbindung und wirkt sich vorteilhaft hinsichtlich der Prozesssicherheit aus. Das Verfahren ist vielschichtig einsetzbar, kostengünstig und erlaubt eine außerordentlich kurze Zykluszeit. Die kurze Zykluszeit ergibt sich insbesondere daraus, dass das Verfahren ein mechanisches Verstellen wie das Schwenken des Bondingkopfs oder das Schwenken der jeweiligen Leiterplatte zur Anpassung der Neigung der Anpressfläche des Bondingkopfs an jene der jeweiligen Leiterplatte, das in situ zwischen den jeweiligen Bondingschritten durchzuführen wäre, vermeidet.

Die Erfindung ist besonders vorteilhaft in Kraftfahrzeugscheinwerferanwendungen, in welchen es notwendig ist, hochpräzise auf einem Kühlkörper positionierte Leiterplatten (hierin auch als Platinen oder Boards bezeichnet) elektrisch zu verbinden. Typischerweise ist bei Kraftfahrzeugscheinwerfern eine entsprechende Neigung der einzelnen Leiterplatten erforderlich, so dass Lichtquellen auf den Leiterplatten zu optischen Achsen von Linsen oder Reflektoren ausgerichtet werden können. Die einzelnen Leiterplatten sind häufig in unmittelbarer Nähe zueinander in einem Scheinwerfergehäuse angeordnet, weshalb sich oftmals geometrisch aufwendige Topologien ergeben, welche dank der Erfindung kostengünstig und in einfacher Weise elektrisch verbindbar sind.

Der Begriff Kraftfahrzeug (KFZ) wie hierin verwendet bezieht sich auf ein- oder mehrspurige motorisierte landgebundene Fahrzeuge wie Motorräder, PKWs, LKWs und dergleichen. Der Begriff Kraftfahrzeugscheinwerfer betrifft insbesondere Frontscheinwerfer und Heckleuchten von Kraftfahrzeugen.

Vorzugsweise sind im Verfahren gemäß der Erfindung die Anpressflächen am Drahtbondingkopf hintereinander in Laufrichtung des Drahtes angeordnet, wodurch eine hochpräzise Positionierung des zu bondenden Drahts an der Bondfläche möglich ist. Ein seitliches Verschieben des Drahtes über die jeweilige Anpressfläche, so wie es für die Zwecke der oben genannten US 3,934,783 notwendig ist und welches das Risiko eines Verrutschen des Drahts am Bondingkopf birgt, ist daher nicht notwendig.

Beim erfindungsgemäßen Verfahren sind die Flächennormale der ersten Bondfläche und die Flächennormale der zweiten Bondfläche in Bezug auf die Anpressrichtung des Drahtbondingkopfs geneigt. Dieser Aspekt ist insbesondere bei Kraftfahrzeugscheinwerferanwendungen von Bedeutung, in welchen es wie erwähnt notwendig ist, hochpräzise auf einem Kühlkörper positionierte Leiterplatten elektrisch miteinander zu verbinden. Typischerweise ist bei Kraftfahrzeugscheinwerfern eine entsprechende Neigung der einzelnen Leiterplatten erforderlich, so dass Lichtquellen auf den Leiterplatten zu optischen Achsen von Linsen oder Reflektoren ausgerichtet werden können. Die jeweiligen Neigungen und somit die Flächennormalen der ersten und zweiten Bondflächen (und entsprechend die Neigungen/Flächennormalen der ersten und zweiten Anpressflächen) hängen bei Scheinwerferanwendungen davon ab, wie die vormontierten elektrisch zu verbindenden Leiterplatten zueinander positioniert sind. Mit zunehmenden Neigungswinkel zwischen der Flächennormalen und der Anpressrichtung des Drahtbondingkopfs wird es schwieriger, die Ultraschallenergie beim Bonding-Prozess einzukoppeln. Der Neigungswinkel zwischen der Flächennormalen der ersten Bondfläche und der Anpressrichtung des Drahtbondingkopfs und/oder zwischen der Flächennormalen der zweiten Bondfläche und der Anpressrichtung des Drahtbondingkopfs ist daher vorzugsweise nicht größer als 6°. Idealerweise ist der Neigungswinkel zwischen der Flächennormalen der ersten Bondfläche und der Anpressrichtung des Drahtbondingkopfs und zwischen der Flächennormalen der zweiten Bondfläche und der Anpressrichtung des Drahtbondingkopfs nicht größer als 6°. Die Anpressrichtung des Drahtbondingkopfs ist vorzugsweise entlang einer Längsachse des Drahtbondingkopfs ausgerichtet.

Entsprechend sind bei dem erfindungsgemäßen Drahtbondingkopf sowohl die Flächennormale der ersten Anpressfläche als auch die Flächennormale der zweiten Anpressfläche des Drahtbondingkopfs in Bezug auf eine Längsachse des Drahtbondingkopfs geneigt. Die Bewegungsrichtung des Drahtbondingkopfs beim Anpressen des Bonddrahts erfolgt typischerweise entlang einer Längsachse des Drahtbondingkopfs. Der Neigungswinkel zwischen der Flächennormalen der ersten Anpressfläche und der Längsachse und/oder zwischen der Flächennormalen der zweiten Anpressfläche und der Längsachse ist nicht größer als 6°. Ferner ist der Neigungswinkel zwischen der Flächennormalen der ersten Anpressfläche und der Längsachse und zwischen der Flächennormalen der zweiten Anpressfläche und der Längsachse nicht größer als 6°.

In einem weiteren Aspekt der Erfindung ist es von Vorteil, wenn der Bonddraht isoliert wird. Eine Isolierung des Bonddrahts verringert bzw. minimiert die Entstehung eines Kurzschlusses zwischen den einzelnen elektronischen Bauteilen, der sich aufgrund der weiteren Verarbeitung und Einbautätigkeit bei Hand und dem Risiko einer Drahtverbiegung ergeben kann. Für die Isolierung steht einem Fachmann aus dem Stand der Technik eine Vielzahl an Methoden zur Verfügung.

Bei einer ersten Variante wird für das Verfahren ein vorisolierter Bonddraht verwendet, d.h. der Bonddraht wird noch vor dem eigentlichen Drahtbondingverfahren mit einer isolierenden Beschichtung versehen. Ein Verfahren zum "Ball"-Bonden vorisolierter Drähte ist zum Beispiel in der US 2003/0234275 A1 beschrieben. Bei einem anderen Verfahren wird der Bonddraht vorab z.B. mittels Fotolack nach an sich bekannter Art periodisch dicht maskiert. Drahtabschnitte ohne Fotolack werden anschließend zum Herstellen einer isolierenden Oxidschicht nach an sich bekannter Art eloxiert. Geeignete isolierende Oxidschichten können z.B. eine Dicke von ca. 10 µm aufweisen. Bei einer Variante ist es auch möglich die Oxidschicht einzufärben. Durch das farbliche Eloxieren ist die korrekte Bondposition mittels eines AOI-Systems überprüfbar. Anschließend werden die Fotolackmasken entfernt, um die zu bondenden nicht-isolierten Drahtabschnitte freizulegen und eine Handhabung mit gängigen Bondgeräten zu gewährleisten. Die Bondverbindung erfolgt an den nichtisolierten Drahtabschnitten. Das Herstellen von Oxidbeschichtungen mit dem Eloxal-Verfahren sowie das Einfärben dieser Schichten sind einem Fachmann hinlänglich bekannt.

Bei einer zweiten, alternativen Variante wird der Bonddraht erst nach dem Drahtbondingprozess isoliert oder er wird während des Drahtbondingverfahrens isoliert. Die nachträglich durchgeführte Isolierung erfolgt über den gesamten Drahtverlauf. Um kurze Zykluszeiten zu erlauben, wird vorzugsweise ein UV-härtender Klebstoff/Schutzlack mit geeigneter Viskosität als isolierendes Material eingesetzt. Weitere Isoliermaterialien sind zum Beispiel Polyvinyl, Polytetrafluorethylen, Epoxyharze oder Polyimid. Verfahren zum Isolieren von Bonddrähten sind aus dem Stand der Technik bekannt. Ein Verfahren zum nachträglichen Isolierung von gebondeten Drähten mit Hilfe von Dosiernadeln ist beispielsweise in der US 2010/0176501 A1 beschrieben. Methoden zum Aufbringen und Isolieren von Bonddrähten während des Drahtbondingverfahrens sind in der US 6,670,214 B1 und der US 6,894,398 B2 geoffenbart. Statt die gebondeten Bonddrähte einzeln zu isolieren, kann auch die gesamte gebondete Einheit in einem Plasmaprozess, z.B. einer plasmaunterstützen chemischen Gasphasenabscheidung (PECVD), mit SiO₂ beschichtet werden. Ein derartiges Verfahren ist beispielsweise in der US 6,033,937 A beschrieben. Die US 6,046,075 A offenbart ein Verfahren zum Erzeugen einer isolierenden Oxidschicht auf Aluminium- oder Kupferbonddrähten in Sauerstoffplasma. Die US 4,860,941 beschreibt die elektrische Isolierung eines Bonddrahts aus Aluminium durch Anodisieren.

Wie erwähnt, ist das erfindungsgemäße Verfahren bei Kraftfahrzeugscheinwerferanwendungen besonders von Vorteil. Zweckmäßigerweise handelt es sich bei dem ersten und dem zweiten Bondkörper daher um Leiterplatten für Kraftfahrzeugscheinwerfer.

Die Erfindung wird im Folgenden anhand von nicht einschränkenden Beispielen und beiliegenden Zeichnungen näher beschrieben, wobei die Zeichnungen zeigen:
Fig. 3a und 3b zeigen einen erfindungsgemäßen Drahtbondingkopf, und
Fig. 4a und 4b veranschaulichen ein Drahtbondingverfahren gemäß der Erfindung unter Verwendung des Drahtbondingkopfs aus Fig. 3a und 3b.

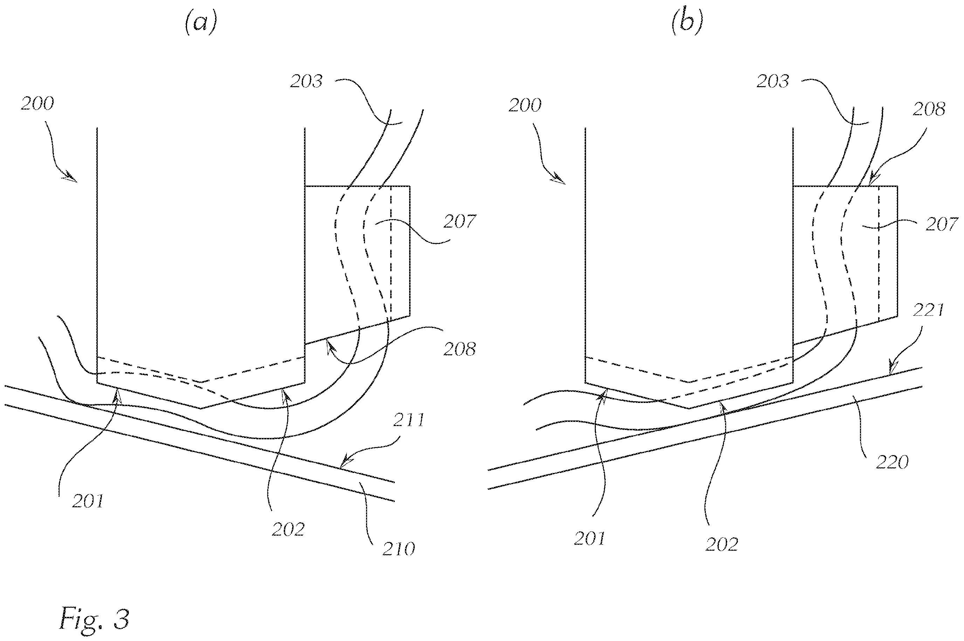

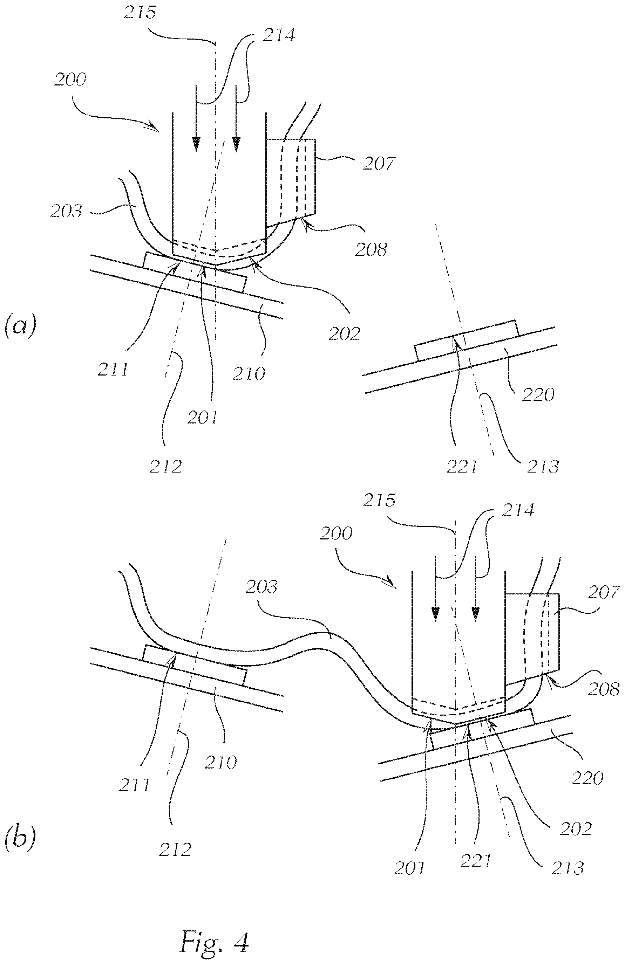

In Fig. 3a und 3b ist ein erfindungsgemäßer Drahtbondingkopf 200 zum Herstellen einer elektrischen Verbindung mit einem Bonddraht 203 zwischen einer ersten Leiterplatte 210 mit einer ersten zu kontaktierenden Fläche 211 (Fig. 3a) und einer zweiten Leiterplatte 220 mit einer zweiten zu kontaktierenden Fläche 221 (Fig. 3b) gezeigt. Die Leiterplatten 210, 220 bzw. deren zu kontaktierenden Flächen 211, 221 sind unterschiedlich geneigt und befinden sich zudem auch auf unterschiedlichen Höhenstufen (siehe auch Fig. 4a und 4b). Die im Beispiel gezeigten Leiterplatten 210, 220 sind auf einem nicht näher dargestellten Kühlkörper einer anzufertigenden Scheinwerferanordnung montiert und elektrisch durch das erfindungsgemäße Drahtbondingverfahren zu verbinden. Der Drahtbondingkopf 200 besitzt zwei unterschiedlich geneigte Anpressflächen 201, 202. Die Neigung der ersten Anpressfläche 201 entspricht dabei im Wesentlichen der Neigung der ersten zu kontaktierenden Fläche 211 der ersten Leiterplatte 210 (Fig. 3a), wohingegen die Neigung der zweiten Anpressfläche 202 im Wesentlichen der Neigung der zweiten zu kontaktierenden Fläche 221 der zweiten Leiterplatte 220 entspricht (Fig. 3b.). Der Drahtbondingkopf 200 verfügt außerdem über eine Zuführung 207 für den Bonddraht 203, die nach an sich bekannter Art aufgebaut ist und eine Öffnung 208 aufweist, durch die der Bonddraht 203 zugeführt bzw. geführt wird. Die Anpressflächen 201, 202 sind am Bondingkopf 200 hintereinander in Laufrichtung des Bonddrahtes 203 angeordnet.

Fig. 4a und 4b veranschaulichen ein erfindungsgemäße Drahtbondingverfahren, das mit Hilfe des Drahtbondingkopfes 200 durchführbar ist und zeigen die Herstellung einer elektrischen Verbindung zwischen der ersten Leiterplatte 210 und der zweiten Leiterplatte 220. Fig. 4a zeigt die Herstellung der ersten Bondverbindung zwischen dem Bonddraht 203 und der ersten zu kontaktierenden Fläche 211 der ersten Leiterplatte 210. Der Bonddraht 203 wird dabei mit der ersten Anpressfläche 201 des Drahtbondingkopfs 200 und mit Hilfe von Ultraschall auf die Fläche 211 aufgepresst. Nach dem Herstellen der ersten Bondverbindung wird der Bonddraht 203 mit Hilfe des Drahtbondingkopfs 200 z.B. mittels eines Schrittmotors weiter zur zweiten Leiterplatte 220 gezogen. Bezugnehmend auf Fig. 4b wird anschließend die zweite Bondverbindung zwischen dem Bonddraht und der zweiten zu kontaktierenden Fläche 221 der zweiten Leiterplatte 220 hergestellt. Der Bonddraht 203 wird dabei mit der zweiten Anpressfläche 202 des Drahtbondingkopfs 200 und mit Hilfe von Ultraschall auf die Fläche 221 aufgepresst. Anschließend wird der Bonddraht 203 nach an sich bekannter Art und Weise abgerissen.

Wie aus den Fig. 4a und 4b ersichtlich ist, sind die Flächennormale 212 der ersten Bondfläche 211 und die Flächennormale 213 der zweiten Bondfläche 221 in Bezug auf die Anpressrichtung des Drahtbondingkopfs 200 geneigt. Die Anpressrichtung des Drahtbondingkopfs 200 (d.h. die Bewegungsrichtung des Kopfs 200 zum Anpressen des Drahts 203) ist durch die Pfeile 214 veranschaulicht und erfolgt entlang einer Längsachse 215 des Drahtbondingkopfs 200. Da die Neigung der ersten Anpressfläche 201 der Neigung der ersten Bondfläche 211 entspricht und die Neigung der zweiten Anpressfläche 202 der Neigung der zweiten Bondfläche 221 entspricht, und die Bondflächen 211 bzw. 221 und Anpressflächen 201 bzw. 202 somit im Wesentlichen parallel zueinander sind, entsprechen die jeweiligen Flächennormalen 212, 213 der ersten und zweiten Bondflächen 211, 221 natürlich im Wesentlichen den jeweiligen Flächennormalen (der Einfachheit halber auch als Flächennormalen 212, 213 bezeichnet) der ersten und zweiten Anpressflächen 201, 202 des Drahtbondingkopfs 200. Die Flächennormale 212 der ersten Anpressfläche 201 und die Flächennormale 213 der zweiten Anpressfläche 202 des Drahtbondingkopfs 200 sind daher in Bezug auf die Längsachse 215 des Drahtbondingkopfs 200 geneigt.

Der Neigungswinkel zwischen der Flächennormalen 212 der ersten Bondfläche 211 und der Anpressrichtung 214 des Drahtbondingkopfs 200 bzw. zwischen der Flächennormalen 213 der zweiten Bondfläche 221 und der Anpressrichtung 214 des Drahtbondingkopfs 200 ist vorzugsweise nicht größer als 6°. Entsprechend ist der Neigungswinkel zwischen der Flächennormalen 212 der ersten Anpressfläche 201 und der Längsachse 215 bzw. zwischen der Flächennormalen 213 der zweiten Anpressfläche 202 und der Längsachse 215 vorzugsweise nicht größer als 6°.

Die folgende Tabelle 1 zeigt geeignete Prozessparameter, die bei dem oben beschriebenen Ultraschall-Drahtbondingprozess zur Herstellung von Bondverbindungen zwischen dem Draht 203 und den Flächen 211, 212 angewendet werden:

**Tabelle 1:**

| | Min. | Max. |
|---|---|---|
| Anpresskräfte [g] | 800 | 1500 |
| Frequenz Ultraschall [kHz] | 60 | 100 |
| Dauer [ms] | 150 | 300 |
| Generatorspannung [V] | 20 | 40 |

Der Bonddraht 203 kann außerdem, wie oben bereits im Detail beschrieben, entweder nach bekannten Techniken vorisoliert sein oder er kann im Anschluss an das Bondingverfahren oder während des Bondingverfahrens mit bekannten Techniken isoliert werden.

## Patentansprüche

1. Drahtbondingverfahren zum Herstellen einer elektrischen Verbindung zwischen einem ersten Bondkörper (210) mit einer ersten zu kontaktierenden Bondfläche (211) und einem zweiten Bondkörper (220) mit einer zweiten zu kontaktierenden Bondfläche (221), wobei die ersten und zweiten Bondflächen (211, 221) unterschiedliche Neigungen aufweisen, wobei das Verfahren die folgenden Schritte umfasst:
a) Bereitstellen eines Drahtbondingkopfs (200) mit zwei unterschiedlich geneigten Anpressflächen (201, 202) und einer Zuführung für einen Bonddraht (203), wobei die Neigung der ersten Anpressfläche (201) im Wesentlichen der Neigung der ersten Bondfläche (211) entspricht und wobei die Neigung der zweiten Anpressfläche (202) im Wesentlichen der Neigung der zweiten Bondfläche (221) entspricht,
b) Herstellen einer ersten Bondverbindung zwischen dem Bonddraht (203) und dem ersten Bondkörper (210), wobei der Draht (203) mittels der ersten Anpressfläche (201) des Drahtbondingkopfs (200) durch Ultraschallbonding mit der ersten Bondfläche (211) verbunden wird, und
c) Herstellen einer zweiten Bondverbindung zwischen dem Draht (203) und dem zweiten Bondkörper (220), wobei der Draht (203) mittels der zweiten Anpressfläche (202) des Drahtbondingkopfs (200) durch Ultraschallbonding mit der zweiten Bondfläche (221) verbunden wird
**dadurch gekennzeichnet, dass**
die Flächennormale (212) der ersten Bondfläche (211) und die Flächennormale (213) der zweiten Bondfläche (221) in Bezug auf die Anpressrichtung (214) des Drahtbondingkopfs (200) geneigt sind.

2. Drahtbondingverfahren nach Anspruch 1, **dadurch gekennzeichnet, dass** die Anpressflächen (201, 202) am Drahtbondingkopf (200) hintereinander in Laufrichtung des Drahtes (203) positioniert sind.

3. Drahtbondingverfahren nach Anspruch 1 oder 2, **dadurch gekennzeichnet, dass** für das Verfahren ein vorisolierter Bonddraht verwendet wird.

4. Drahtbondingverfahren nach Anspruch 1 oder 2, **dadurch gekennzeichnet, dass** der Bonddraht (203) nach dem Herstellen oder während des Herstellens der elektrischen Verbindung isoliert wird.

5. Drahtbondingverfahren nach einem der Ansprüche 1 bis 4, **dadurch gekennzeichnet, dass** der Neigungswinkel zwischen der Flächennormalen (212) der ersten Bondfläche (211) und der Anpressrichtung (214) des Drahtbondingkopfs (200) und/oder zwischen der Flächennormalen (213) der zweiten Bondfläche (221) und der Anpressrichtung (214) des Drahtbondingkopfs (200) nicht größer als 6° ist.

6. Drahtbondingverfahren nach Anspruch 5, **dadurch gekennzeichnet, dass** der Neigungswinkel zwischen der Flächennormalen (212) der ersten Bondfläche (211) und der Anpressrichtung des Drahtbondingkopfs (200) und zwischen der Flächennormalen (213) der zweiten Bondfläche (221) und der Anpressrichtung (214) des Drahtbondingkopfs (200) nicht größer als 6° ist.

7. Drahtbondingverfahren nach einem der Ansprüche 1 bis 6, **dadurch gekennzeichnet, dass** die Anpressrichtung (214) des Drahtbondingkopfs (200) entlang einer Längsachse (215) des Drahtbondingkopfs (200) ausgerichtet ist.

8. Drahtbondingverfahren nach einem der Ansprüche 1 bis 7, **dadurch gekennzeichnet, dass** es sich bei dem ersten und dem zweiten Bondkörper (210, 220) um Leiterplatten für Kraftfahrzeugscheinwerfer handelt.

9. Drahtbondingkopf (200) zum Herstellen einer elektrischen Verbindung zwischen einem ersten Bondkörper (210) mit einer ersten zu kontaktierenden Bondfläche (211) und einem zweiten Bondkörper (220) mit einer zweiten zu kontaktierenden Bondfläche (221), wobei der Drahtbondingkopf (200) zwei unterschiedlich geneigte Anpressflächen (201, 202) und eine Zuführung (207) für einen Bonddraht (203) aufweist, die Anpressflächen (201, 202) am Drahtbondingkopf (200) hintereinander in Laufrichtung des Bonddrahtes (203) positioniert sind, und sowohl die Flächennormale (212) der ersten Anpressfläche (201) als auch die Flächennormale (213) der zweiten Anpressfläche (202) in Bezug auf eine Längsachse (215) des Drahtbondingkopfs (200) geneigt sind,
**dadurch gekennzeichnet, dass**
der Neigungswinkel zwischen der Flächennormalen (212) der ersten Anpressfläche (201) und der Längsachse (215) und zwischen der Flächennormalen (213) der zweiten Anpressfläche (202) und der Längsachse (215) nicht größer als 6° ist.

## Claims

1. Wire bonding method for making an electrical connection between a first bonding body (210) having a first bonding surface (211) to be contacted and a second bonding body (220) having a second bonding surface (221) to be contacted, the first and second bonding surfaces (211, 221) having different inclinations, the method comprising the steps of:
a) providing a wire bonding head (200) having two differently inclined contacting surfaces (201, 202) and a feed for a bonding wire (203), wherein the inclination of the first contacting surface (201) substantially corresponds to the inclination of the first bonding surface (211) and wherein the inclination of the second contacting surface (202) substantially corresponds to the inclination of the second bonding surface (221),
b) making a first bonding connection between the bonding wire (203) and the first bonding body (210), wherein the wire (203) is ultrasonically bonded to the first bonding surface (211) by means of the first contact surface (201) of the wire bonding head (200), and
c) making a second bond connection between the wire (203) and the second bonding body (220), wherein the wire (203) is ultrasonically bonded to the second bonding surface (221) by means of the second contact surface (202) of the wire bonding head (200)
**characterized in that**
the surface normal (212) of the first bonding surface (211) and the surface normal (213) of the second bonding surface (221) are inclined with respect to the pressing direction (214) of the wire bonding head (200).

2. Wire bonding method according to claim 1, **characterized in that** the pressing surfaces (201, 202) on the wire bonding head (200) are positioned one behind the other in the running direction of the wire (203).

3. Wire bonding method according to claim 1 or 2, **characterized in that** a pre-insulated bonding wire is used for the method.

4. Wire bonding method according to claim 1 or 2, **characterized in that** the bonding wire (203) is insulated after making or during making the electrical connection.

5. Wire bonding method according to any one of claims 1 to 4, **characterized in that** the angle of inclination between the surface normal (212) of the first bonding surface (211) and the pressing direction (214) of the wire bonding head (200) and/or between the surface normal (213) of the second bonding surface (221) and the pressing direction (214) of the wire bonding head (200) is not greater than 6°.

6. Wire bonding method according to claim 5, **characterized in that** the inclination angle between the surface normal (212) of the first bonding surface (211) and the pressing direction of the wire bonding head (200) and between the surface normal (213) of the second bonding surface (221) and the pressing direction (214) of the wire bonding head (200) is not greater than 6°.

7. Wire bonding method according to any one of claims 1 to 6, **characterized in that** the pressing direction (214) of the wire bonding head (200) is aligned along a longitudinal axis (215) of the wire bonding head (200).

8. Wire bonding method according to any one of claims 1 to 7, **characterized in that** the first and second bonding bodies (210, 220) are printed circuit boards for motor vehicle headlights.

9. Wire bonding head (200) for making an electrical connection between a first bonding body (210) having a first bonding surface (211) to be contacted and a second bonding body (220) having a second bonding surface (221) to be contacted, wherein the wire bonding head (200) has two differently inclined pressing surfaces (201, 202) and a feed (207) for a bonding wire (203), the contact pressure surfaces (201, 202) on the wire bonding head (200) are positioned one behind the other in the direction of travel of the bonding wire (203), and both the surface normal (212) of the first contact pressure surface (201) and the surface normal (213) of the second contact pressure surface (202) are inclined with respect to a longitudinal axis (215) of the wire bonding head (200) **characterized in that**
the angle of inclination between the surface normal (212) of the first pressing surface (201) and the longitudinal axis (215) and between the surface normal (213) of the second pressing surface (202) and the longitudinal axis (215) is not greater than 6°.

## Revendications

1. Procédé de liaison par fil pour établir une connexion électrique entre un premier corps de liaison (210) ayant une première surface de liaison (211) à contacter et un deuxième corps de liaison (220) ayant une deuxième surface de liaison (221) à contacter, les première et deuxième surfaces de liaison (211, 221) ayant des inclinaisons différentes, le procédé comprenant les étapes suivantes :
a) Préparation d'une tête de liaison par fil (200) avec deux surfaces de pression (201, 202) d'inclinaison différente et une alimentation pour un fil de liaison (203), l'inclinaison de la première surface de pression (201) correspondant sensiblement à l'inclinaison de la première surface de liaison (211) et l'inclinaison de la deuxième surface de pression (202) correspondant sensiblement à l'inclinaison de la deuxième surface de liaison (221),
b) Réalisation d'une première connexion de liaison entre le fil de liaison (203) et le premier corps de liaison (210), le fil (203) étant relié par liaison ultrasonique à la première surface de liaison (211) au moyen de la première surface de pression (201) de la tête de liaison de fil (200), et
c) Réalisation d'une deuxième connexion de liaison entre le fil (203) et le deuxième corps de liaison (220), le fil (203) étant relié à la deuxième surface de liaison (221) par liaison ultrasonique au moyen de la deuxième surface de pression (202) de la tête de liaison de fil (200).
**caractérisé en ce que**
la normale à la surface (212) de la première surface de liaison (211) et la normale à la surface (213) de la deuxième surface de liaison (221) sont inclinées par rapport à la direction de pression (214) de la tête de liaison par fil (200).

2. Procédé de liaison par fil selon la revendication 1, **caractérisé en ce que** les surfaces de pression (201, 202) sur la tête de liaison par fil (200) sont positionnées l'une derrière l'autre dans la direction de déplacement du fil (203).

3. Procédé de liaison par fil selon la revendication 1 ou 2, **caractérisé en ce qu'**un fil de liaison préisolé est utilisé pour le procédé.

4. Procédé de liaison par fil selon la revendication 1 ou 2, **caractérisé en ce que** le fil de liaison (203) est isolé après la fabrication ou pendant la fabrication de la connexion électrique.

5. Procédé de liaison par fil selon l'une des revendications 1 à 4, **caractérisé en ce que** l'angle d'inclinaison entre la normale à la surface (212) de la première surface de liaison (211) et la direction de pression (214) de la tête de liaison par fil (200) et/ou entre la normale à la surface (213) de la deuxième surface de liaison (221) et la direction de pression (214) de la tête de liaison par fil (200) n'est pas supérieur à 6°.

6. Procédé de liaison par fil selon la revendication 5, **caractérisé en ce que** l'angle d'inclinaison entre la normale à la surface (212) de la première surface de liaison (211) et la direction de pression de la tête de liaison par fil (200) et entre la normale à la surface (213) de la deuxième surface de liaison (221) et la direction de pression (214) de la tête de liaison par fil (200) n'est pas supérieur à 6°.

7. Procédé de liaison par fil selon l'une des revendications 1 à 6, **caractérisé en ce que** la direction de pressage (214) de la tête de liaison par fil (200) est orientée le long d'un axe longitudinal (215) de la tête de liaison par fil (200).

8. Procédé de liaison par fil selon l'une quelconque des revendications 1 à 7, **caractérisé en ce que** le premier et le deuxième corps de liaison (210, 220) sont des cartes de circuits imprimés pour phares de véhicules automobiles.

9. Tête de liaison par fil (200) pour réaliser une liaison électrique entre un premier corps de liaison (210) avec une première surface de liaison (211) à contacter et un deuxième corps de liaison (220) avec une deuxième surface de liaison (221) à contacter, la tête de liaison par fil (200) présentant deux surfaces de pression (201, 202) inclinées différemment et une amenée (207) pour un fil de liaison (203), les surfaces de pression (201, 202) sont positionnées sur la tête de liaison par fil (200) l'une derrière l'autre dans la direction de déplacement du fil de liaison (203), et aussi bien la normale à la surface (212) de la première surface de pression (201) que la normale à la surface (213) de la deuxième surface de pression (202) sont inclinées par rapport à un axe longitudinal (215) de la tête de liaison par fil (200),
**caractérisé en ce que**
l'angle d'inclinaison entre la normale à la surface (212) de la première surface de pression (201) et l'axe longitudinal (215) et entre la normale à la surface (213) de la deuxième surface de pression (202) et l'axe longitudinal (215) n'est pas supérieur à 6°.
